# FASCICULE DE BREVET EUROPEEN

(11) **EP 2 158 605 B1**
(45) Date de publication et mention de la délivrance du brevet: **27.10.2010**
(21) Numéro de dépôt: 08826649.9
(22) Date de dépôt: 20.06.2008
(51) Int. Cl.: H01L 21/98, H01L 25/065

(54) **PROCÉDÉ DE FABRICATION D'UN ASSEMBLAGE DE PUCES RELIÉES MÉCANIQUEMENT AU MOYEN D'UNE CONNEXION SOUPLE**
VERFAHREN ZUR HERSTELLUNG EINES SATZES VON DURCH EINE FLEXIBLE VERBINDUNG MECHANISCH VERBUNDENEN CHIPS
METHOD FOR PRODUCING A SET OF CHIPS MECHANICALLY INTERCONNECTED BY MEANS OF A FLEXIBLE CONNECTION

(30) Priorité: 21.06.2007 FR 0704445
(43) Date de publication de la demande: 03.03.2010
(73) Titulaire: Commissariat à l'Énergie Atomique et aux Énergies Alternatives, 75015 Paris (FR)
(72) Inventeur: BRUN, Jean, F-38800 Champagnier (FR); MOUREY, Bruno, F-38500 Coublevie (FR); VICARD, Dominique, F-38330 Saint Nazaire les Eymes (FR)
(74) Mandataire: de Jong, Jean Jacques
(86) Numéro de dépôt international: PCT/FR2008/000867
(87) Numéro de publication internationale: WO 2009/013409

(56) Documents cités:
- WO-A-00/67539
- WO-A-02/084617
- WO-A-03/021679
- WO-A-2005/048302
- WO-A-2006/089439
- US-A1- 2002 094 701
- US-A1- 2003 157 783
- US-A1- 2005 026 328

## Description

### Domaine technique de l'invention

L'invention est relative à un procédé de fabrication d'un assemblage de puces reliées mécaniquement au moyen d'une connexion souple, le procédé comportant :
- la réalisation, sur un substrat, de puces, comportant chacune une zone d'accueil,
- la connexion en série des zones d'accueil des puces de l'assemblage par un élément de liaison,
- la désolidarisation des puces.

### État de la technique

Lorsqu'une puce microélectronique ne peut répondre seule à une fonction précise, cette dernière est en général connectée à une ou plusieurs autres puces afin d'obtenir la fonctionnalité recherchée. De nombreuses techniques existent aujourd'hui pour connecter mécaniquement et électriquement des puces microélectroniques entre elles. La technique conventionnelle consiste, une fois les puces formées sur un substrat et libérées par sciage, à réaliser une connexion mécanique rigide entre les puces. Les puces, alors fixées sur un support rigide, sont ensuite connectées électriquement avant qu'un enrobage de protection ne soit formé. Cette première approche, consistant à réaliser la connexion sur un support rigide, est classiquement utilisée lorsqu'il existe une grande complexité dans la connexion des puces. Cependant, cette approche a pour principal inconvénient d'utiliser un support mécanique rigide qui est particulièrement mal adapté à une intégration dans des structures souples.

Une deuxième approche, décrite dans le document WO-A-02/084617 consiste à intégrer des puces sur un ensemble de fibres ou d'éléments filaires afin de réaliser un dispositif. Cette intégration des puces au sein des fibres peut être réalisée par enrobage. Les différentes puces peuvent être reliées entre elles au moyen de filaments conducteurs pouvant être également enrobés ou intégrés au sein de la fibre elle même. Cependant ce document n'indique pas comment réaliser la fixation des filaments en matériau conducteur entre les différentes puces et l'enrobage sur les fibres.

Un autre procédé de fabrication d'un assemblage de puces (20) reliées mécaniquement au moyen d'une connexion souple est décrit dans le document WO03/021679.

### Objet de l'invention

L'invention a pour objet un procédé de réalisation d'un assemblage de puces connectées mécaniquement entre elles, de façon souple, qui soit facile à mettre en oeuvre.

Cet objet est atteint par le fait la zone d'accueil étant constituée par une rainure, l'élément de liaison est un fil qui est encastré dans ladite rainure pour réaliser ledit moyen de connexion souple

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1 à 3 représentent une vue schématique, en coupe, des étapes successives d'un premier mode de réalisation selon l'invention,
- les figures 4 et 5 représentent une vue schématique, en coupe, des étapes successives d'un deuxième mode de réalisation selon l'invention,
- la figure 6 représente une vue schématique, en coupe, d'un troisième mode de réalisation selon l'invention,
- les figures 7 et 8 représentent une vue schématique, en coupe, des étapes successives d'un quatrième mode de réalisation selon l'invention,
- la figure 9 représente une vue schématique, en vue de dessus, de la figure 8, après photolithographie,
- les figures 10 et 11 représentent une vue schématique, en coupe, des étapes successives d'un cinquième mode de réalisation selon l'invention.

### Description de modes de réalisation préférentiels de l'invention

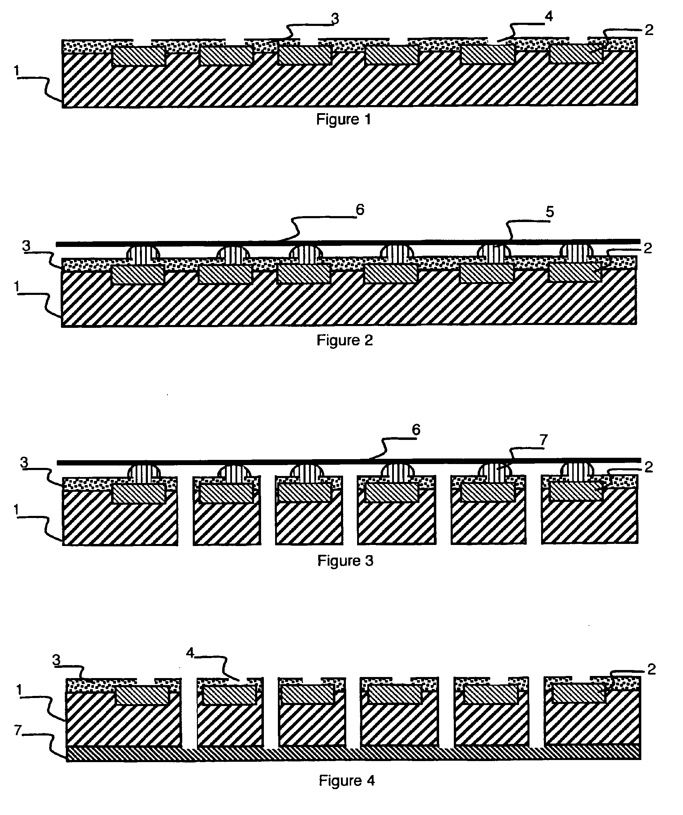

Comme illustré sur la figure 1, une pluralité de puces microélectroniques 2 sont intégrées sur un substrat 1, qui peut être un substrat de silicium. Les puces 2 peuvent être identiques ou non. Une étape conventionnelle de photolithographie est réalisée pour délimiter au moyen d'une résine photosensible 3, une zone d'accueil 4 sur chaque puce microélectronique 2.

Comme illustré sur la figure 2, un agent de fixation, pouvant être de la colle 5 est déposé sur les zones d'accueil 4.

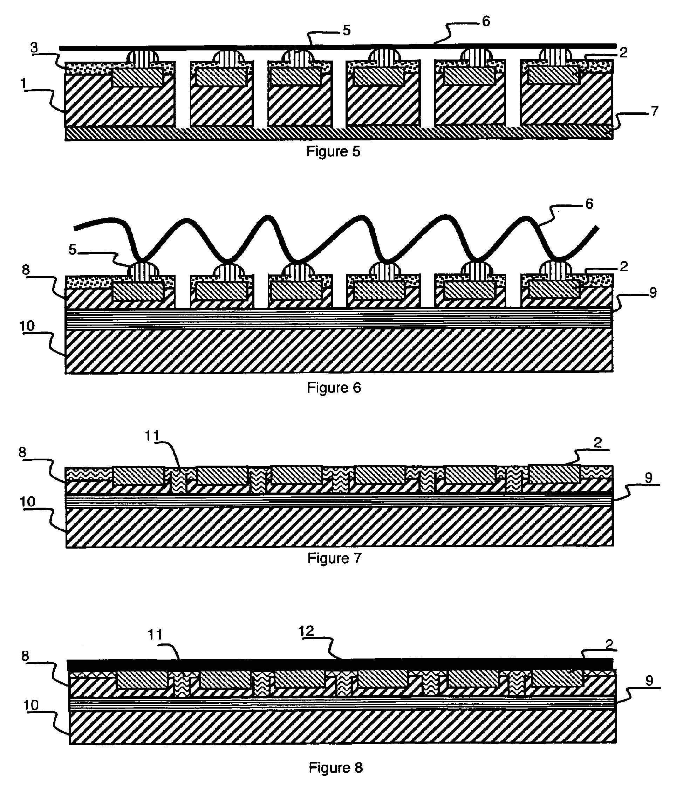

Un élément de liaison 6 est ensuite fixé sur chaque puce 2 au moyen de la colle 5 pour relier les puces entre elles. L'élément de liaison 6 est de forme linéaire. Il peut avoir une section ronde ou carrée et être constitué par un fil ou un ensemble de fils. L'élément de liaison 6 peut être réalisé dans un matériau isolant, par exemple en fibre naturelle ou synthétique. Dans ce dernier cas, il peut, par exemple, être constitué par un polymère, comme le polyester ou le polyamide. Cependant, l'élément de liaison 6 est avantageusement en matériau conducteur, par exemple métallique, pour assurer une connexion électrique entre les puces 2. Dans ce cas, la colle 5 est avantageusement conductrice et la zone d'accueil 4 peut contenir une zone de contact qui réalise la connexion électrique avec les composants de la puce 2. La longueur de l'élément de liaison 6 reliant deux zones d'accueil 4 et, donc, deux puces 2, est fonction de leur utilisation future. Ainsi, par exemple, la longueur de l'élément de liaison 6 entre deux zones d'accueil peut être supérieure à la distance séparant initialement les deux zones d'accueil 4 (voir figure 6). A titre d'exemple, des longueurs plus importantes de l'élément de liaison 6 sont souhaitables pour permettre ultérieurement un stockage des puces 2, par exemple en bobine ou rouleau, ou si les puces 2 utilisent l'élément de liaison en tant qu'antenne. Dans ce cas, l'élément de liaison 6 peut former une boucle entre deux zones d'accueil 4.

Comme illustré à la figure 3, le substrat 1 est ensuite structuré de façon à désolidariser, les unes des autres, les puces 2 et la partie correspondante du substrat 1. Les puces 2 sont alors reliées en série uniquement par une connexion mécanique souple au moyen de l'élément de liaison 6. La désolidarisation des puces 2 est réalisée dans le cas d'un substrat 1 massif de manière classique, par exemple par sciage, en prenant soin de ne pas sectionner l'élément de liaison 6.

Ainsi, la fixation entre l'élément de liaison 6 et la puce 2 est nettement facilitée car toutes les puces sont initialement solidaires d'un même support rigide, constitué par le substrat 1. Cette opération se rapproche alors des techniques classiquement utilisées dans l'industrie microélectronique.

Dans une variante de réalisation, dans laquelle la connexion entre les puces 2 est non seulement mécanique mais également électrique, des puces 2 présentant des fonctionnalités différentes peuvent être connectées les unes aux autres. Ces puces 2 peuvent alors être intégrées sur le même substrat 1 ou sur des substrats différents et ensuite connectées au moyen d'un même l'élément de liaison 6.

Dans une variante de réalisation, illustrée aux figures 4 et 5, un support provisoire 7, constituant un film de maintien, est initialement déposé sur la face du substrat 1 opposée à celle comprenant les puces 2. Comme illustré à la figure 4, les puces 2 sont désolidarisées les unes des autres au niveau du substrat 1, après formation des zones d'accueil 4 dans la résine. Elles restent néanmoins mécaniquement solidaires les unes des autres par l'intermédiaire du support provisoire 7. Cette désolidarisation partielle des puces 2 est réalisée par tout procédé adapté, par exemple, par sciage ou par gravure plasma.

Comme illustré à la figure 5, l'élément de liaison 6 est ensuite, comme précédemment, fixé à chacune des puces 2 sur la zone d'accueil 4. Le support provisoire 7 est ensuite retiré et les puces 2 ne sont plus alors reliées entre elles qu'au moyen de la connexion mécanique souple constituée par l'élément de liaison 6, comme sur la figure 3.

Dans une autre variante de réalisation, illustrée à la figure 6, les puces 2 sont intégrées sur un substrat sur isolant (SOI). Celui-ci comporte classiquement un substrat actif 8 disposé sur un isolant enterré 9, formé sur un substrat de support 10. Le substrat actif 8 peut être assimilé au substrat 1 tandis que l'isolant enterré 9 et le substrat de support 10 constituent un support provisoire. De manière analogue à la figure 5, sur la figure 6, les puces 2 ont déjà été partiellement désolidarisées au niveau du substrat actif 8 et l'élément de connexion 6 fixé à chacune des puces 2. Les puces peuvent ensuite être désolidarisées du support provisoire constitué par l'isolant enterré 9 et le substrat de support 10, par exemple par gravure humide de l'isolant enterré 9 notamment au moyen d'acide fluorhydrique. Il est également possible de désolidariser le support provisoire par clivage, ce dernier est alors solidaire de la puce, mais ne fournit plus aucune fonction mécanique. Comme précédemment, les puces 2 ne restent connectées entre elles que par l'élément de liaison 6.

Dans une variante (non représentée), l'élément de liaison 6 est fixé par soudure et non par collage, à chaque puce 2 au niveau d'une zone de contact de la puce, par exemple en forme de plot. Dans ce cas, la zone de contact constitue la zone d'accueil 4 et les étapes de dépôt d'une résine photosensible 3 et de formation des zones d'accueil par photolithographie sont éliminées. L'élément de liaison 6 est, de préférence, maintenu sur la zone de contact et une vibration ultrasonore est exercée afin de réaliser la soudure. L'opération est ensuite réitérée sur chaque zone de contact pour effectuer les différentes soudures. Si l'élément de liaison 6 doit servir de connexion électrique entre les puces 2, il est en matériau conducteur, de préférence métallique, et la zone de contact de la puce est également en matériau conducteur, de préférence métallique. La soudure peut, comme sur la figure 2, être réalisée avant découpe des puces ou, comme sur les figures 4 et 6, après découpe partielle des puces, avant retrait du substrat provisoire (7 ou 9 et 10). Cette soudure peut aussi être réalisée, par exemple, par apport de matériau, par plasma, par électrolyse, par pulvérisation cathodique...

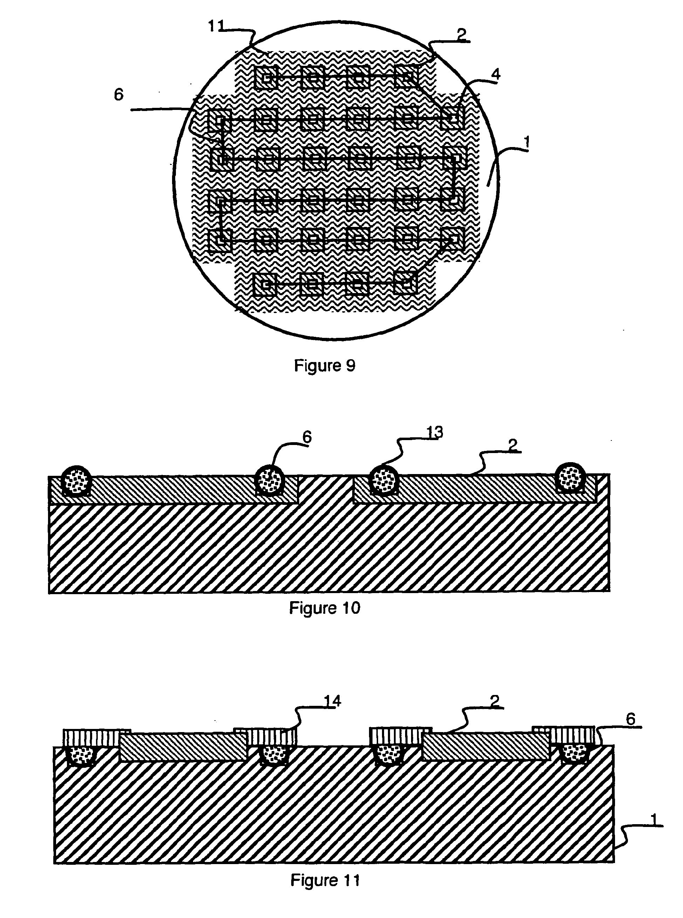

Dans une autre variante de réalisation, illustrée aux figures 7 à 9, les puces 2 sont intégrées sur un substrat sur isolant. La fixation de l'élément de liaison 6 n'est réalisée ni par soudure ni par collage. Les puces 2 sont désolidarisées les unes des autres au niveau de la couche de substrat actif 8 par sciage standard ou par gravure sèche jusqu'à l'isolant enterré 9. Puis, un matériau de remplissage 11 par exemple une résine, remplit les traits de découpe ainsi formés dans la couche 8. Dans l'exemple représenté sur les figures 7 à 8, le matériau de remplissage 11 remplit tout l'espace situé entre les deux puces 2. Une couche 12 formée par le matériau de liaison destiné à constituer les éléments de liaison est alors déposée sur l'ensemble ainsi obtenu (figure 8). Le matériau de liaison 12 peut être conducteur ou bien isolant, par exemple de type minéral, par exemple en nitrure ou oxyde de silicium, ou de type organique, par exemple en parylène ®. Ce dépôt est structuré de façon classique, par exemple par photolithographie et gravure plasma pour former une piste conductrice ou isolante constituant l'élément de liaison 6 connectant les puces entre elles au niveau de leurs zones d'accueil 4 formées par les plots de contact, comme illustré en vue de dessus à la figure 9. Le matériau de remplissage 11 est ensuite éliminé par tout procédé adapté et les puces 2 sont désolidarisées de leur support, par exemple par élimination de l'isolant enterré 9.

Dans un autre mode de réalisation, illustré aux figures 10 et 11, une zone d'accueil 4 est constituée par au moins un évidement réalisé dans la puce 2, préférentiellement à coté des composants microélectroniques. L'évidement peut, par exemple, être constitué par une rainure ou un trou. De multiples formes de rainures ou de trous sont possibles notamment à base carrée, en V , V tronqué ou en arc de cercle. Les dimensions ainsi que la forme de l'évidement seront choisies préférentiellement en fonction des caractéristiques de l'élément de liaison 6. A titre d'exemple, la profondeur et la largeur d'une rainure peuvent varier dans une gamme allant de 20 à 100 µm pour un élément de liaison 6 de 20 à 100 µm de diamètre. Les évidements peuvent être réalisés par toute technique adaptée, par exemple, par gravure sèche, par sciage ou alors au moyen d'un gravure humide par exemple avec une solution de KOH.

Comme illustré à la figure 10, un élément de liaison 6 de forme filaire, souple, est alors encastré dans chacune des rainures, de section carrée sur la figure 10. Si l'élément de liaison 6 est électriquement conducteur, il est avantageusement enrobé d'une couche en matériau isolant 13, de façon à éviter tout court-circuit avec le substrat 1. Dans le cas contraire, une isolation électrique de la rainure peut être réalisée par tout procédé connu. Si le matériau isolant 13 est un polymère thermodurcissable, une insertion à chaud est préférentiellement utilisée afin de faciliter l'encastrement et de coller l'élément de liaison 6 à l'intérieur de la rainure.

Les puces 2 sont ensuite de façon classique désolidarisées de la couche support et ne sont plus connectées entre elles que par une connexion souple au moyen de l'élément de liaison 6.

Comme illustré à la figure 11, une étape supplémentaire de connexion électrique entre l'élément de liaison 6 et la puce 2 est réalisée dans le cas où une connexion électrique de la puce 2 avec l'extérieur doit être effectuée au moyen de l'élément de liaison 6. La connexion électrique entre l'élément 6 et un plot de contact de la puce 2 peut être réalisée sous forme d'une piste conductrice 14 par tout moyen connu, par exemple par jet d'encre, sérigraphie, ou utilisation d'une colle conductrice.

Dans une variante de réalisation non représentée, la connexion électrique peut également être réalisée, par exemple, au moyen d'une couche conductrice qui est déposée sur une portion intérieure de la rainure. La connexion électrique peut également être assurée au moyen d'une couche conductrice qui sert de couche d'arrêt lors de la formation de la rainure d'encastrement du fil (connexion électrique par le fond de la rainure) ou qui est gravée lors de la formation de la rainure (connexion électrique par le bord de la rainure). Tous ces modes de réalisation ont pour but la transmission d'un courant entre le fil qui est conducteur et la puce.

Sur les figures 10 et 11, deux évidements sont associés à chaque puce et deux éléments de liaison 6 peuvent connecter une puce à deux puces différentes. Il est également possible que chaque puce comporte deux rainures et que deux éléments de liaisons relient alors chaque puce. La puce comporte alors une rainure additionnelle.

Ce mode de réalisation peut être avantageusement utilisé avec un substrat qui comporte un film provisoire, par exemple un substrat SOI, d'une manière analogue à celle décrite dans les modes de réalisation précédents. La désolidarisation du substrat SOI peut alors être réalisée comme précédemment par gravure d'un diélectrique enterré ou par clivage du substrat.

De manière générale, un grand nombre de puces 2, formées sur une même plaquette, peuvent être connectées en série les unes aux autres par au moins un élément de liaison souple et désolidarisées les unes des autres. On obtient ainsi un assemblage de puces sous forme de guirlande souple, pouvant être stockée sous forme de bobine ou rouleau et découpée à la demande. L'assemblage est avantageusement enrobé par un polymère ou tout autre matériau de protection vis-à-vis des agressions du milieu extérieur.

Ce type d'assemblage peut, par exemple, être avantageusement utilisé pour équiper d'antennes des puces RFID. Une pluralité de puces 2, de type RFID, sont ainsi formées et connectées par un élément de liaison 6 conducteur, souple. La longueur de l'élément de liaison 6 séparant deux puces 2 correspond avantageusement à la longueur utile de l'antenne. Le sectionnement de l'élément de liaison 6 est alors réalisé entre deux puces 2 et permet d'obtenir des puces RFID munies de leurs antennes.

L'invention n'est pas limitée aux modes de réalisation décrits ci-dessus. En particulier, différents types de puces provenant de substrats distincts peuvent être connectés par un même élément de liaison 6 permettant ainsi de réaliser des fonctionnalités complexes. Par ailleurs, la fabrication d'un assemblage peut utiliser une combinaison des caractéristiques décrites ci-dessus en relation avec les différents modes de réalisation.

L'invention n'est pas limitée aux modes de réalisation décrits ci-dessus, et comprend une autre variante de réalisation (non représentée), dans laquelle l'assemblage de puces n'est pas réalisé au moyen d'un même fil qui est connecté à l'ensemble des puces ou a un grand nombre de puces. Dans ce mode de réalisation, deux puces consécutives sont connectées l'une à l'autre au moyen d'au moins un fil élémentaire. Ainsi, un fil élémentaire est relié a deux puces et chaque fil élémentaire de l'assemblage de puces assure la connexion souple de l'assemblage. De cette manière, les puces étant connectées deux à deux par un fil élémentaire, il est plus facile de réaliser une fonctionnalisation de l'assemblage des puces, c'est-à-dire l'association des puces dans un ordre désiré afin de permet l'obtention de fonctions technologiques recherchées. Il est alors possible qu'une même rainure accueille deux fils élémentaires différents à chacune de ses extrémités et que ces fils soient connectés chacun à zone conductrice différente.

De manière générale, à partir d'un substrat, il est possible de former un seul assemblage qui regroupe toutes les puces ou alors plusieurs assemblages qui sont avantageusement constitués par une organisation précise de différentes puces du substrat.

## Revendications

1. Procédé de fabrication d'un assemblage de puces (2) reliées mécaniquement au moyen d'une connexion souple, le procédé comportant :
- la réalisation, sur un substrat (1), de puces (2), comportant chacune une zone d'accueil (4),
- la connexion en série des zones d'accueil (4) des puces (2) de l'assemblage par un élément de liaison (6),
- la désolidarisation des puces (2),
procédé **caractérisé en ce que** la zone d'accueil étant constituée par une rainure, l'élément de liaison est un fil qui est encastré dans ladite rainure pour réaliser ledit moyen de connexion souple.

2. Procédé selon la revendication 1, **caractérisé en ce que** l'élément de liaison (6) est électriquement conducteur.

3. Procédé selon l'une des revendications 1 et 2, **caractérisé en ce que** le substrat étant initialement solidaire d'un support provisoire (7, 9, 10), le procédé comporte une étape de découpe partielle des puces (2), au niveau du substrat (1, 8), avant la connexion en série des zones d'accueil (4), le support provisoire étant éliminé lors de la désolidarisation des puces.

4. Procédé selon la revendication 3, **caractérisé en ce que** le support provisoire est un film (7) de maintien, formé sur la face du substrat opposé aux puces (2).

5. Procédé selon la revendication 3, **caractérisé en ce que** le support provisoire est un substrat SOI (9, 10) avec désolidarisation par élimination de l'isolant enterré (9).

6. Procédé selon l'une quelconque des revendications 1 à 5, **caractérisé en ce que** les rainures comportent une section concave, carrée ou circulaire.

7. Procédé selon l'une quelconque des revendications 1 à 6, **caractérisé en ce qu'**une rainure additionnelle étant formée sur les puces, un fil additionnel relie chaque puce.

8. Procédé selon l'une quelconque des revendications 1 à 7, **caractérisé en ce que** l'assemblage de puces forme une bobine.

9. Procédé selon l'une quelconque des revendications 1 à 8, **caractérisé en ce que** deux puces consécutives sont connectées par un fil élémentaire.

## Claims

1. A method for producing an assembly of chips (2) mechanically interconnected by means of a flexible connection, the method comprising:
- producing chips (2) on a substrate (1), each chip comprising a receiving area (4),
- connecting the receiving areas (4) of the chips (2) of the assembly in series by means of a connecting element (6),
- releasing the chips (2),
a method **characterized in that** the receiving area being formed by a groove, the connecting element is a thread that is embedded in said groove to achieve said flexible connecting means.

2. The method according to claim 1, **characterized in that** the connecting element (6) is electrically conducting.

3. The method according to one of claims 1 and 2, **characterized in that** the substrate being initially secured to a provisional support (7, 9, 10), the method comprises a step of partial dicing of the chips (2), at the level of the substrate (1, 8), before connection of the receiving areas (4) in series, the provisional support being eliminated when the chips are released.

4. The method according to claim 3, **characterized in that** the provisional support is a securing film (7) formed on the surface of the substrate opposite the chips (2).

5. The method according to claim 3, **characterized in that** the provisional support is a SOI substrate (9, 10) with release by elimination of the buried insulator (9).

6. The method according to any one of claims 1 to 5, **characterized in that** the grooves comprise a concave, square or circular cross-section.

7. The method according to any one of claims 1 to 6, **characterized in that** an additional groove being formed on the chips, an additional thread connects each chip.

8. The method according to any one of claims 1 to 7, **characterized in that** the set of chips forms a coil.

9. The method according to any one of claims 1 to 8, **characterized in that** two consecutive chips are connected by an individual thread.

## Patentansprüche

1. Verfahren zur Herstellung eines Satzes von durch eine flexible Verbindung mechanisch verbundenen Chips (2), wobei das Verfahren umfasst:
- die Herstellung von Chips (2), die jeweils einen Aufnahmebereich (4) umfassen, auf einem Substrat (1),
- das In-Serie-Schalten der Aufnahmebereiche (4) der Chips (2) des Satzes durch ein Verbindungselement (6),
- das Trennen der Chips (2),
ein Verfahren, das **dadurch gekennzeichnet ist, dass** der Aufnahmebereich aus einer Nut besteht und das Verbindungselement ein Draht ist, der in dieser Nut eingespannt ist, um die genannte flexible Verbindungsvorrichtung zu bilden.

2. Verfahren nach Anspruch 1, **dadurch gekennzeichnet, dass** das Verbindungselement (6) elektrisch leitend ist.

3. Verfahren nach einem der Ansprüche 1 und 2, **dadurch gekennzeichnet, dass**, nachdem das Substrat zunächst fest verbunden mit einem provisorischen Träger (7, 9, 10) ist, das Verfahren einen Schritt des parziellen Zerschneidens der Chips (2) im Bereich des Substrats (1, 8) umfasst, und zwar vor dem In-Serie-Schalten der Aufnahmebereiche (4), wobei der provisorische Träger beim Trennen der Chips entfernt wird.

4. Verfahren nach Anspruch 3, **dadurch gekennzeichnet, dass** der provisorische Träger eine Halteschicht (7) ist, die auf der den Chips (2) entgegengesetzten Seite des Substrats hergestellt ist.

5. Verfahren nach Anspruch 3, **dadurch gekennzeichnet, dass** der provisorische Träger ein SOI-Substrat (9, 10) ist und durch Entfernen des vergrabenen Isolators (9) abgetrennt wird.

6. Verfahren nach einem der Ansprüche 1 bis 5, **dadurch gekennzeichnet, dass** die Nuten einen konkaven, quadratischen oder kreisförmigen Querschnitt aufweisen.

7. Verfahren nach einem der Ansprüche 1 bis 6, **dadurch gekennzeichnet, dass**, wenn eine zusätzliche Nut auf den Chips gebildet ist, ein zusätzlicher Draht jeden Chip anschließt.

8. Verfahren nach einem der Ansprüche 1 bis 7, **dadurch gekennzeichnet, dass** der Chipsatz eine Spule bildet.

9. Verfahren nach einem der Ansprüche 1 bis 8, **dadurch gekennzeichnet, dass** zwei aufeinanderfolgende Chips durch einen Elementardraht miteinander verbunden sind.
